(19) Europäisches Patentamt
European Patent Office
Office européen des brevets

(11) EP 3 053 979 A1

(12) EUROPEAN PATENT APPLICATION
published in accordance with Art. 153(4) EPC

(43) Date of publication:
**10.08.2016 Bulletin 2016/32**

(21) Application number: **14849721.7**

(22) Date of filing: **02.09.2014**

(51) Int Cl.:
***C09K 3/14*** *(2006.01)*
***B24B 37/00*** *(2012.01)*
***C09G 1/02*** *(2006.01)*
***H01L 21/304*** *(2006.01)*

(86) International application number:
**PCT/JP2014/073076**

(87) International publication number:
**WO 2015/045757 (02.04.2015 Gazette 2015/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.09.2013 JP 2013204170**

(71) Applicant: **Fujimi Incorporated**
**Kiyosu-shi, Aichi 452-8502 (JP)**

(72) Inventor: **TAMADA, Shuichi**
**Kiyosu-shi**
**Aichi 452-8502 (JP)**

(74) Representative: **Grünecker Patent- und Rechtsanwälte**
**PartG mbB**
**Leopoldstraße 4**
**80802 München (DE)**

# (54) POLISHING COMPOSITION

(57) The present invention provides a polishing composition having excellent storage stability. The present invention relates to a polishing composition including abrasive grains and an oxidant containing a halogen atom, a value (A/B) obtained by dividing the total number (A) (unit: number) of silanol groups contained in the abrasive grains in the polishing composition by a concentration (B) (unit: % by mass) of the oxidant in the polishing composition being $8 \times 10^{23}$ or less.

EP 3 053 979 A1

## Description

### TECHNICAL FIELD

The present invention relates to a polishing composition.

### BACKGROUND ART

In recent years, a new fine processing technology has been developed in accordance with high integration and high performance of LSI. A chemical mechanical polishing (hereinafter, also simply referred to as CMP) method is one of these technologies, and is often used in an LSI manufacturing process, particularly in flattening an interlayer insulating film in a multilayer wiring forming process, forming a metal plug, and forming embedded wiring (damascene wiring). This technology is, for example, disclosed in US 4944836. In the damascene wiring technology, it is possible to simplify a wiring process or to improve a yield and reliability. Application thereof is considered to expand in the future.

In a high-speed logic device, for the damascene wiring, copper is currently mainly used as a wiring metal due to low resistivity. Copper is considered to be used also for a memory device represented by a DRAM in the future. In a general method of metal CMP, a polishing pad is pasted onto a circular polishing platen, a surface of the polishing pad is impregnated with a polishing agent, a surface of a substrate on which a metal film is formed is pressed against the surface of the polishing pad, and the polishing platen is rotated while a predetermined pressure (hereinafter, also simply referred to as polishing pressure) is applied from the back surface thereof. The metal film in a projecting part is removed by mechanical friction between the polishing agent and the projecting part of the metal film.

On the other hand, on a lower layer of the wiring such as copper or a copper alloy, tantalum, a tantalum alloy, a tantalum compound, or the like is formed as a barrier layer for preventing copper diffusion into an interlayer insulating film. Therefore, in parts other than the wiring part in which copper or a copper alloy is embedded, it is necessary to remove an exposed barrier layer by CMP. However, in general, the barrier layer has a higher hardness than copper or a copper alloy. Therefore, in CMP using a combination of polishing materials for copper or a copper alloy, a sufficient CMP rate is not obtained in many cases.

Meanwhile, tantalum, a tantalum alloy, a tantalum compound, or the like used as a barrier layer is chemically stable, etching thereof is difficult, and mechanical polishing thereof is more difficult than copper or a copper alloy due to a high hardness. Recently, as a material for the barrier layer, a noble metal material such as ruthenium, a ruthenium alloy, or a ruthenium compound has been studied. A noble metal material such as ruthenium, a ruthenium alloy, or a ruthenium compound is excellent in terms of having a lower resistivity than tantalum, a tantalum alloy, or a tantalum compound, being capable of film formation by a chemical vapor deposition method (CVD), and being applicable to narrower width wiring. However, a noble metal material such as ruthenium, a ruthenium alloy, or a ruthenium compound is chemically stable and has a high hardness similarly to tantalum, a tantalum alloy, or a tantalum compound. Therefore, polishing thereof is difficult.

A noble metal material is used, for example, as an electrode material in a process for manufacturing a DRAM capacitor structure. Polishing using a polishing composition is performed for removing a part made of a material containing a noble metal such as a ruthenium simple substance or ruthenium oxide ($RuO_x$). However, similarly to the above-described noble metal material for a barrier layer, in general, it takes time for removing a material containing a chemically stable noble metal. Therefore, it is strongly demanded to further improve this type of polishing composition for improving throughput.

In general, a polishing agent used in CMP includes an oxidant and abrasive grains. A basic mechanism of CMP by this polishing agent for CMP is considered to be as follows. That is, first, a surface of a metal film is oxidized by an oxidant, and the obtained oxidized layer on the surface of the metal film is scraped off by abrasive grains. An oxidized layer in a recess part of the surface of the metal film does not come into contact with a polishing pad much, and is not scraped off by the abrasive grains. Therefore, the metal film in a projecting part is removed and a surface of a substrate is flattened with progress of CMP.

CMP requires a high polishing rate with respect to a wiring metal, stability of the polishing rate, and a low defect density in a polished surface. However, a film containing ruthenium is chemically more stable and has a higher hardness than another damascene wiring metal film such as copper or tungsten. Therefore, it is more difficult to polish the film containing ruthenium. As a polishing liquid for such a film containing a noble metal, particularly a film containing ruthenium, for example, in JP 2004-172326 A, a polishing liquid containing polishing abrasive grains, an oxidant, and benzotriazole has been proposed.

As a technology for reducing power consumption of a transistor or improving performance thereof (operating characteristics), a high mobility channel material to increase a mobility of a carrier has been studied. In a channel having these carrier transport characteristics improved, a drain current during ON time is enhanced. Therefore, it is possible reduce a power supply voltage while a sufficient ON current is obtained. This combination brings about higher performance

of MOSFET (metal oxide semiconductor field-effect transistor) at a low power.

As the high mobility channel material, application of a III-V group compound, a IV group compound, Ge (germanium), graphene only including C (carbon), or the like is expected. Currently, in forming a III-V group compound channel, there is a problem that a technology to increase crystallinity of the channel and to control and grow a shape thereof well has not been established. Therefore, a IV group compound, particularly SiGe, Ge, or the like, which is more easily introduced than the III-V group compound, has been studied actively.

A channel using a high mobility material can be formed by polishing a polishing object containing a IV group compound channel and/or a Ge channel (hereinafter, also referred to as a Ge material part) and a part containing a silicon material (hereinafter, also referred to as a silicon material part). In this case, in addition to polishing the Ge material part at a high polishing rate, it is required not to generate a step which is caused by etching on a surface of the polishing object after the polishing object is polished. For example, JP 2010-130009 A (US 8338302) and JP 2010-519740 W (US 2011/117740 A) disclose a polishing composition used for polishing a Ge substrate.

## SUMMARY OF INVENTION

However, polishing compositions described in JP 2010-130009 A (US 8338302) and JP 2010-519740 W (US 2011/117740 A) have low storage stability disadvantageously.

An object of the present invention is to provide a polishing composition having excellent storage stability.

The present inventors made intensive studies in order to solve the above-described problems. As a result, the present inventors have found that the above-described problems can be solved by a polishing composition having a value obtained by dividing the total number of silanol groups contained in abrasive grains in the polishing composition by a concentration of an oxidant in the polishing composition within a specific range. Based on the above finding, the present inventors have completed the present invention.

That is, the present invention relates to a polishing composition including abrasive grains and an oxidant containing a halogen atom, a value (A/B) obtained by dividing the total number (A) (unit: number) of silanol groups contained in the abrasive grains in the polishing composition by a concentration (B) (unit: % by mass) of the oxidant in the polishing composition being $8 \times 10^{23}$ or less.

## DESCRIPTION OF EMBODIMENTS

The present invention relates to a polishing composition including abrasive grains and an oxidant containing a halogen atom, a value (A/B) obtained by dividing the total number (A) (unit: number) of silanol groups contained in the abrasive grains in the polishing composition by a concentration (B) (unit: % by mass) of the oxidant in the polishing composition being $8 \times 10^{23}$ or less. By having such a structure, storage stability of the polishing composition is improved.

A detailed reason for improving the storage stability of the polishing composition of the present invention is unknown. However, it is considered that reduction in the storage stability is caused by decomposition of the oxidant contained in the polishing composition. Meanwhile, in the polishing composition of the present invention, the value (A/B) obtained by dividing the total number (A) (unit: number) of silanol groups contained in the abrasive grains in the polishing composition by the concentration (B) (unit: % by mass) of the oxidant in the polishing composition is within a specific range. The value A/B means a ratio between the concentration of the oxidant and the number of silanol groups affecting decomposition of the oxidant. It is considered that, by controlling this value to a certain value or less, a ratio of the decomposition of the oxidant is suppressed within an allowable range and the storage stability of the polishing composition is improved.

The present inventors have found, as a mechanism for suppressing the decomposition of the oxidant, that a halogen oxidant and a silanol group are reacted with each other, specifically, the halogen oxidant acts on the silanol group, and the oxidant itself is decomposed to reduce a concentration thereof. An amount of the oxidant decomposed by an interaction with a certain number of silanol groups is constant. By increasing the concentration of the oxidant or reducing the concentration of the abrasive grains, a ratio of the oxidant to be reduced by the decomposition with respect to the concentration of the oxidant added initially is decreased. As a result, it is considered that polishing performance is stable and the storage stability of the polishing composition is improved.

The above-described mechanism is based on estimation, and the present invention is not in any way limited to the mechanism.

[Polishing object]

A polishing object according to the present invention is not particularly limited. However, the present invention is preferably used for polishing a polishing object having a layer containing a IV group material. More specifically, the present invention is used for polishing the polishing object and manufacturing a substrate. The polishing object may

further include a silicon material part. Examples of the IV group material include Ge (germanium), SiGe (silicon germanium), and the like. Examples of the silicon material include polysilicon, silicon oxide, silicon nitride, and the like.

Next, a structure of the polishing composition of the present invention will be described in detail.

[Abrasive grains]

The abrasive grains contained in the polishing composition have an action to polish a polishing object mechanically, and increase a polishing rate of the polishing object by the polishing composition.

The abrasive grains used in the present invention are not particularly limited as long as the abrasive grains contain a silanol group. Specific examples thereof include particles formed of a metal oxide such as silica, alumina, zirconia, or titania. The abrasive grains may be used singly or in mixture of two or more kinds thereof. For the abrasive grains, a commercially available product or a synthetic product may be used.

Among these abrasive grains, silica is preferable, and colloidal silica is particularly preferable.

The abrasive grains may be surface-modified. Usual colloidal silica has a zeta potential value of nearly zero under acidic conditions, and therefore tends to cause agglomeration without electrical repulsion between silica particles under the acidic conditions. In contrast, abrasive grains which have been surface-modified so as to have a relatively large negative zeta potential value even under acidic conditions, are strongly repelled with each other and are well dispersed even under acidic conditions. As a result, the storage stability of the polishing composition is improved. Such surface-modified abrasive grains can be obtained by mixing a metal such as aluminum, titanium, or zirconium, or an oxide thereof with abrasive grains and doping the resulting mixture into a surface of the abrasive grains.

Among these abrasive grains, colloidal silica obtained by immobilizing an organic acid is particularly preferable. An organic acid is immobilized to a surface of colloidal silica contained in the polishing composition, for example, by chemically bonding a functional group of the organic acid to the surface of the colloidal silica. Only by making the colloidal silica and the organic acid coexist, the organic acid is not immobilized to the colloidal silica. For example, sulfonic acid as an organic acid can be immobilized to colloidal silica by a method described in "Sulfonic acid-functionalized silica through quantitative oxidation of thiol groups", Chem. Commun. 246-247 (2003). Specifically, colloidal silica on a surface of which sulfonic acid is immobilized can be obtained by coupling a silane coupling agent having a thiol group such as 3-mercaptopropyl trimethoxysilane to colloidal silica and then oxidizing the thiol group with hydrogen peroxide. Alternatively, carboxylic acid can be immobilized to colloidal silica by a method described in "Novel Silane Coupling Agents Containing a Photolabile 2-Nitrobenzyl Ester for Introduction of a Carboxy Group on the Surface of Silica Gel", Chemistry Letters, 3, 228-229 (2000). Specifically, colloidal silica on a surface of which carboxylic acid is immobilized can be obtained by coupling a silane coupling agent containing a photoreactive 2-nitrobenzyl ester to colloidal silica and then irradiating the resulting product with light.

The lower limit of an average primary particle diameter of the abrasive grain is preferably 5 nm or more, more preferably 7 nm or more, and still more preferably 10 nm or more. The upper limit of the average primary particle diameter of the abrasive grain is preferably 500 nm or less, more preferably 300 nm or less, and still more preferably 200 nm or less. Within such a range, the polishing rate of the polishing object by the polishing composition is improved, and it is possible to further suppress dishing on the surface of the polishing object after the polishing object is polished using the polishing composition. The average primary particle diameter of the abrasive grain is calculated, for example, based on a specific surface area of the abrasive grain measured by a BET method.

The lower limit of a content (concentration) of the abrasive grains in the polishing composition is preferably 0.0002 g/L or more, more preferably 0.002 g/L or more, and still more preferably 0.02 g/L or more. The upper limit of the content (concentration) of the abrasive grains in the polishing composition is preferably 200 g/L or less, more preferably 100 g/L or less, and still more preferably 50 g/L or less. Within such a range, a high polishing rate is obtained while cost is suppressed, and processing can be performed efficiently.

In the polishing composition of the present invention, the value (A/B) obtained by dividing the total number (A) (unit: number) of silanol groups contained in the abrasive grains in the polishing composition by the concentration (B) (unit: % by mass) of the oxidant in the polishing composition is $8 \times 10^{23}$ or less. The value A/B means a ratio between the concentration of the oxidant and the number of silanol groups affecting decomposition of the oxidant. It is considered that, by controlling this value, a ratio of the decomposition of the oxidant is suppressed within an allowable range and the storage stability of the polishing composition is improved.

When the value A/B is more than $8 \times 10^{23}$, a decomposition ratio of the oxidant by a silanol group is high, and polishing performance greatly changes disadvantageously. The upper limit of the value A/B is $8 \times 10^{23}$ or less, and is preferably $3 \times 10^{23}$ or less.

The total number (A) of silanol groups contained in the abrasive grains in the polishing composition can be calculated by the following method.

Primary particle diameter [nm] of abrasive grain (measured value) : A diameter (primary particle diameter) of an abrasive grain is calculated based on a specific surface area (SA) calculated by the BET method using a formula of

SA = $4\pi R^2$, assuming that the abrasive grain is spherical.

Volume per abrasive grain (calculated value): calculated by the following formula using the primary particle diameter calculated based on the specific surface area (SA)

$$\text{Volume per abrasive grain} = 4/3\pi \times (\text{primary particle diameter of abrasive grain}/2)^3$$

Weight per abrasive grain (calculated value): calculated by the following formula using the calculated volume per abrasive grain

$$\text{Weight per abrasive grain} = \text{volume per abrasive grain} \times \text{specific gravity of abrasive grain (2.2 in colloidal silica)}$$

Surface area per abrasive grain (calculated value): calculated by the following formula using the primary particle diameter calculated based on the specific surface area (SA)

$$\text{Surface area per abrasive grain} = 4\pi \times (\text{primary particle diameter of abrasive grain}/2)^2$$

The number of abrasive grains in polishing composition (calculated value): calculated by dividing a concentration of the abrasive grains in the polishing composition by a weight per abrasive grain

Total surface area of abrasive grains in polishing composition [$nm^2$] (calculated value) : calculated by a product of the surface area per abrasive grain and the number of the abrasive grains in the polishing composition

The number of silanol groups (measured value): The number of silanol groups per surface area [Silanol count/$nm^2$] determined by a Sears method was calculated.

The Sears method was performed with reference to G.W. Sears, Jr., "Determination of Specific Surface Area of Colloidal Silica by Titration with Sodium Hydroxide", Analytical Chemistry, 28 (12), 1981 (1956). A silica solution (1 wt%) was used for the measurement. A dropping amount of NaOH added per one time was 0.01 ml and an addition interval was 30 seconds.

The total number (number) (A) of silanol groups contained in abrasive grains in polishing composition (calculated value): calculated by a product of the number of silanol groups (measured value)[count/nm] determined by the Sears method and the total surface area of the abrasive grains in the polishing composition[$nm^2$] (calculated value) calculated by using the BET specific surface area and the concentration of the abrasive grains in the polishing composition.

Concentration (B) of oxidant (measured value): calculated from an addition amount of a chemical agent when the chemical agent in which the concentration of the oxidant is known is used. Alternatively, quantitative determination is performed by oxidation-reduction titration. For example, in NaClO, quantitative determination is performed by titration using a method No. 318 notified by the Ministry of Health, Labour and Welfare on September 29, 2003.

The number of silanol groups contained in abrasive grains with respect to 1% by mass of oxidant (calculated value) : calculated by dividing the total number (number) (A) of silanol groups contained in the abrasive grains in the polishing composition (calculated value) by the concentration (B) of the oxidant.

The total number (A) of silanol groups contained in the abrasive grains in the polishing composition can be controlled by increase or decrease in the concentration of the abrasive grains or increase or decrease in the number of silanol groups per area of the abrasive grains. The value (A/B) obtained by dividing the total number (A) (unit: number) of silanol groups contained in the abrasive grains in the polishing composition by the concentration (B) (unit: % by mass) of the oxidant in the polishing composition can be controlled by increase or decrease in the addition amount of the oxidant in addition to increase or decrease in the concentration of the abrasive grains and increase or decrease in the number of silanol groups per area of the abrasive grains.

[Oxidant]

The oxidant used in the present invention contains a halogen atom. Specific examples of such an oxidant

include a halogen acid and a salt thereof; a halous acid or a salt thereof, such as chlorous acid ($HClO_2$), bromous acid ($HBrO_2$), iodous acid ($HIO_2$), sodium chlorite ($NaClO_2$), potassium chlorite ($KClO_2$), sodium bromite ($NaBrO_2$), or potassium bromite ($KBrO_2$); a halogen acid or a salt thereof, such as sodium chlorate ($NaClO_3$), potassium chlorate ($KClO_3$), silver chlorate ($AgClO_3$), barium chlorate ($Ba(ClO_3)_2$), sodium bromate ($NaBrO_3$), potassium bromate ($KBrO_3$), or sodium iodate ($NaIO_3$); a perhalogen acid or a salt thereof, such as perchloric acid ($HClO_4$), perbromic acid ($HBrO_4$), periodic acid ($HIO_4$), sodium periodate ($NaIO_4$), potassium periodate ($KIO_4$), or tetrabutyl ammonium periodate ($(C_4H_9)_4NIO_4$); a hypohalous acid such as hypofluorous acid (HFO), hypochlorous acid (HClO), hypobromous acid (HBrO), or hypoiodous acid (HIO); a salt of hypofluorous acid such as lithium hypofluorite (LiFO), sodium hypofluorite (NaFO), potassium hypofluorite (KFO), magnesium hypofluorite ($Mg(FO)_2$), calcium hypochlorite ($Ca(FO)_2$), or barium hypofluorite ($Ba(FO)_2$); a salt of hypochlorous acid such as lithium hypochlorite (LiClO), sodium hypochlorite (NaClO), potassium hypochlorite (KClO), magnesium hypochlorite ($Mg(ClO)_2$), calcium hypochlorite ($Ca(ClO)_2$), barium hypochlorite ($Ba(ClO)_2$), t-butyl hypochlorite (t-BuClO), ammonium hypochlorite ($NH_4ClO$), or triethanolamine hypochlorite ($(CH_2CH_2OH)_3N{\cdot}ClO$); a salt of hypobromous acid such as lithium hypobromite (LiBrO), sodium hypobromite (NaBrO), potassium hypobromite (KBrO), magnesium hypobromite ($Mg(BrO)_2$), calcium hypobromite ($Ca(BrO)_2$), barium hypobromite (Ba(BrO)2), ammonium hypobromite ($NH_4BrO$), or triethanolamine hypobromite ($(CH_2CH_2OH)_3N{\cdot}BrO$); and a salt of hypoiodous acid such as lithium hypoiodite (LiIO), sodium hypoiodite (NaIO), potassium hypoiodite (KIO), magnesium hypoiodite ($Mg(IO)_2$), calcium hypoiodite ($Ca(IO)_2$), barium hypoiodite ($Ba(IO)_2$), ammonium hypoiodite ($NH_4IO$), or triethanolamine hypoiodite ($(CH_2CH_2OH)_3N{\cdot}IO$). These oxidants containing a halogen atom can be used singly or in mixture of two or more kinds thereof.

Among these oxidants containing a halogen atom, chlorous acid, hypochlorous acid, chloric acid, perchloric acid, and salts thereof are preferable. As the salt, an ammonium salt, a sodium salt, a potassium salt, or the like can be selected.

The lower limit of the concentration (B) of the oxidant in the polishing composition of the present invention is preferably 0.0001% by mass or more, more preferably 0.001% by mass or more, and still more preferably 0.005% by mass or more. The upper limit of the concentration (B) of the oxidant in the polishing composition of the present invention is preferably less than 0.5% by mass, more preferably 0.4% by mass or less, and still more preferably 0.3% by mass or less. Within such a range, a high polishing rate is obtained and processing can be performed efficiently while excessive dissolution of the layer containing a IV group material is suppressed.

[Stability improver]

The polishing composition of the present invention preferably further contains a stability improver. By containing the stability improver, the storage stability of the polishing composition of the present invention is further improved.

Examples of such a stability improver include a compound having an amide bond. In addition, specific examples thereof include a compound having a structure represented by General Formula (1) or (2).

[Chemical Formula 1]

General Formula (1)

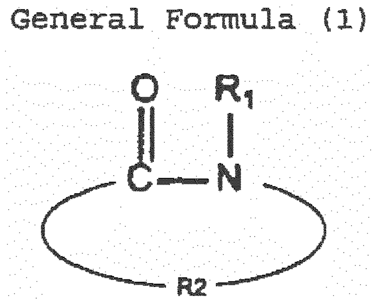

In the above General formula (1), $R_1$ represents a hydrogen atom, a hydroxyl group, an aldehyde group, a carbonyl group, a carboxyl group, an amino group, an imino group, an azo group, a nitro group, a nitroso group, a thiol group, a sulfonic acid group, a phosphoric acid group, a halogen group, an alkyl group (a linear, branched or cyclic alkyl group, including a bicycloalkyl group and an active methine group), an aryl group, or an acyl group. These functional groups may have a substituent or have no substituent. In the general formula (1), R2 represents a heterocyclic structure having two or more carbon atoms. These functional groups may have a substituent or have no substituent.

A substituent is not particularly limited. However, examples thereof include the following.

A halogen atom (a fluorine atom, a chlorine atom, a bromine atom, or an iodine atom), an alkyl group (a linear, branched or cyclic alkyl group, including a bicycloalkyl group and an active methine group), an alkenyl group, an alkynyl group, an aryl group, a heterocyclic group (any substitution position), an acyl group, an alkoxycarbonyl group, an aryloxycarbonyl group, a heterocyclic oxycarbonyl group, a carbamoyl group, an N-hydroxy carbamoyl group, an N-acyl carbamoyl group, an N-sulfonyl carbamoyl group, an N-carbamoyl carbamoyl group, a thiocarbamoyl group, an N-sulfamoyl carbamoyl group, a carbazoyl group, a carboxy group or a salt thereof, an oxalyl group, an oxamoyl group, a cyano group, a carbonimidoyl group, a formyl group, a hydroxy group, an alkoxy group (including a group containing repeated units of an ethyleneoxy group or propyleneoxy group), an aryloxy group, a heterocyclic oxy group, an acyloxy group, an (alkoxy or aryloxy) carbonyloxy group, a carbamoyloxy group, a sulfonyloxy group, an amino group, an (alkyl, aryl, or heterocyclic) amino group, an acylamino group, a sulfonamido group, a ureido group, a thioureido group, an N-hydroxy ureido group, an imido group, an (alkoxy or aryloxy) carbonylamino group, a sulfamoylamino group, a semicarbazide group, thiosemicarbazide group, a hydrazino group, an ammonio group, an oxamoylamino group, an N- (alkyl or aryl) sulfonyl ureido group, an N-acylureido group, an N-acyl sulfamoylamino group, a hydroxyamino group, a nitro group, a heterocyclic group containing a quaternary nitrogen atom (for example, a pyridinio group, an imidazolio group, a quinolinio group, or an isoquinolinio group), an isocyano group, an imino group, a mercapto group, an (alkyl, aryl, or heterocyclic) thio group, an (alkyl, aryl, or heterocyclic) dithio group, an (alkyl or aryl) sulfonyl group, an (alkyl or aryl) sulfinyl group, a sulfo group or a salt thereof, a sulfamoyl group , an N-acyl sulfamoyl group, an N-sulfonylsulfamoyl group or a salt thereof, a phosphino group, a phosphinyl group, a phosphinyloxy group, a phosphinylamino group, and a silyl group.

Here, the active methine group means a methine group substituted with two electron-withdrawing groups. The electron-withdrawing group means an acyl group, an alkoxycarbonyl group, an aryloxycarbonyl group, a carbamoyl group, an alkylsulfonyl group, an arylsulfonyl group, a sulfamoyl group, a trifluoromethyl group, a cyano group, a nitro group, or a carbonimidoyl group. Here, the two electron-withdrawing groups may form a cyclic structure by bonding with each other. The salt means a cation such as an alkali metal, an alkaline earth metal, or a heavy metal, or an organic cation such as an ammonium ion or a phosphonium ion.

These substituents may be further substituted with a substituent similar to the above-described substituent.

Specific examples of the compound represented by the above-described General Formula (1) include 2-pyrrolidone, 1-methyl-2-pyrrolidone, 1-ethyl-2-pyrrolidone, 5-methyl-2-pyrrolidone, 1-(2-hydroxymethyl)-2-pyrrolidone, 1-(2-hydroxyethyl)-2-pyrrolidone,
1-(chloromethyl)-2-pyrrolidone, 1-acetyl-2-pyrrolidone, 5-thioxopyrrolidin-2-one, pyroglutamic acid, methyl pyroglutamate, ethyl pyroglutamate, succinimide, N-bromosuccinimide, N-chlorosuccinimide, N-iodosuccinimide, N-hydroxysuccinimide, N-methyl succinimide, N-phenyl succinimide, N-methyl-2-phenyl succinimide, 2-ethyl-2-methyl succinimide, hexahydrophthal imide, pyromellitic diimide, hexahydrophthalimide, 2-oxopyrrolidine-1-acetamide,
1-methyl-5-oxo-2-pyrrolidine acetic acid, 2-(2-oxopyrrolidin-1-yl) butanamide, 5-methoxypyrrolidin-2-one, versimide, 4-hydroxy-2-oxo-1-pyrrolidineacetamide,
4-hydroxy-2-pyrrolidone, 1-hydroxy-3-amino-2-pyrrolidone, 1-(2-hydroxyethyl)-2-pyrrolidone,
2-pyrrolidone-5-carboxylic
acid,1,2-dihydro-3H-pyrrolizin-3-one, and the like.

[Chemical Formula 2]

General Formula (2)

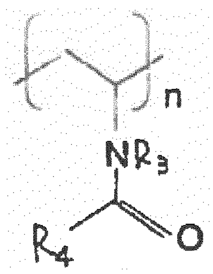

In the above General formula (2), $R_3$ and $R_4$ each independently represent a hydrogen atom, a hydroxyl group,

an aldehyde group, a carbonyl group, a carboxyl group, an amino group, an imino group, an azo group, a nitro group, a nitroso group, a thiol group, a sulfonic acid group, a phosphoric acid group, a halogen group, an alkyl group (a linear, branched or cyclic alkyl group, including a bicycloalkyl group and an active methine group), an aryl group, or an acyl group. These functional groups may have a substituent or have no substituent, n represents the number of a repeating unit.

Specific examples of the compound represented by General Formula (2) include poly-N-vinylacetamide, and the like.

These stability improvers can be used singly or in mixture of two or more kinds thereof.

The lower limit of a content of the stability improver in the polishing composition of the present invention is preferably 0.001% by mass or more, more preferably 0.01% by mass or more, and still more preferably 0.1% by mass or more. The upper limit of the content of the stability improver in the polishing composition of the present invention is preferably 20% by mass or less, more preferably 10% by mass or less, and still more preferably 5% by mass or less. Within such a range, the storage stability of the polishing composition of the present invention can be further improved while cost is suppressed.

[pH of polishing composition]

The pH of the polishing composition of the present invention is preferably 5 or more, and more preferably 7 or more. The pH of the polishing composition of the present invention is preferably 12 or less, and more preferably 10 or less. Within such a range, polishing can be performed efficiently while excessive dissolution of the polishing object is suppressed.

The pH can be adjusted by adding an appropriate amount of pH adjusting agent. A pH adjusting agent used, if necessary, for adjusting the pH of the polishing composition to a desired value may be either an acid or an alkali, and either an inorganic compound or an organic compound. Specific examples of the acid include an inorganic acid such as sulfuric acid, nitric acid, boric acid, carbonic acid, hypophosphorous acid, phosphorous acid, or phosphoric acid; and an organic acid such as a carboxylic acid including formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid, or an organic sulfuric acid including methanesulfonic acid, ethanesulfonic acid, and isethionic acid. Specific examples of the alkali include a hydroxide of an alkali metal, such as potassium hydroxide; an amine such as ammonia, ethylene diamine, or piperazine; and a quaternary ammonium salt such as tetramethylammonium or tetraethylammonium. These pH adjusting agents can be used singly or in mixture of two or more kinds thereof.

[Water]

The polishing composition of the present invention preferably contains water as a dispersion medium or a solvent for dispersing or dissolving components. Water containing impurities as less as possible is preferable from a viewpoint of suppressing inhibiting actions of other components. Specifically, pure water or ultra-pure water obtained by removing foreign matters through a filter after impurity ions are removed using an ion exchange resin, or distilled water is preferable.

[Other components]

The polishing composition of the present invention may contain, if necessary, another component such as a metal corrosion inhibitor, a preservative, a fungicide, a water-soluble polymer, or an organic solvent to dissolve a poorly soluble organic substance. Hereinafter, the metal corrosion inhibitor, the preservative, and the fungicide, which are preferable other components, will be described.

[Metal corrosion inhibitor]

By adding a metal corrosion inhibitor to the polishing composition, it is possible to further suppress generation of a recess on a side of the wiring in polishing using the polishing composition. In addition, it is possible to further suppress dishing on the surface of the polishing object after the polishing object is polished using the polishing composition.

The metal corrosion inhibitor which can be used is not particularly limited, but is preferably a heterocyclic compound or a surfactant. The number of members of the heterocyclic ring in the heterocyclic compound is not particularly limited. The heterocyclic compound may be a monocyclic compound or a polycyclic compound having a condensed ring. The metal corrosion inhibitor may be used singly or in mixture of two or more kinds thereof. As the metal corrosion

inhibitor, a commercially available product or a synthetic product may be used.

Specific examples of the heterocyclic compound which can be used as a metal corrosion inhibitor include a nitrogen-containing heterocyclic compound such as a pyrrole compound, a pyrazole compound, an imidazole compound, a triazole compound, a tetrazole compound, a pyridine compound, a pyrazine compound, a pyridazine compound, a pyrindine compound, an indolizine compound, an indole compound, an isoindole compound, an indazole compound, a purine compound, a quinolizine compound, a quinoline compound, an isoquinoline compound, a naphthyridine compound, a phthalazine compound, a quinoxaline compound, a quinazoline compound, a cinnoline compound, a buteridin compound, a thiazole compound, an isothiazole compound, an oxazole compound, an isoxazole compound, and a furazan compound.

More specifically, examples of the pyrazole compound include 1H-pyrazole, 4-nitro-3-pyrazole carboxylic acid, 3,5-pyrazole carboxylic acid, 3-amino-5-phenylpyrazole, 5-amino-3-phenylpyrazole, 3,4,5-bromopyrazole, 3-aminopyrazole, 3,5-dimethylpyrazole, 3,5-dimethyl-1-hydroxymethylpyrazole, 3-methylpyrazole, 1-methylpyrazole, 3-amino-5-methylpyrazole, 4-amino-pyrazolo[3,4-d]pyrimidine, allopurinol, 4-chloro-1H-pyrazolo[3,4-D]pyrimidine, 3,4-dihydroxy-6-methylpyrazolo(3,4-B)-pyridine, 6-methyl-1H-pyrazolo[3,4-b]pyridin-3-amine, and the like.

Examples of the imidazole compound include imidazole, 1-methylimidazole, 2-methylimidazole, 4-methylimidazole, 1,2-dimethylpyrazole, 2-ethyl-4-methylimidazole, 2-isopropylimidazole, benzimidazole, 5,6-dimethylbenzimidazole, 2-aminobenzimidazole, 2-chlorobenzimidazole, 2-methylbenzimidazole, 2-(1-hydroxyethyl)benzimidazole, 2-hydroxybenzimidazole, 2-phenylbenzimidazole, 2,5-dimethylbenzimidazole, 5-methylbenzimidazole, 5-nitrobenzimidazole, 1H-purine, and the like.

Examples of the triazole compound include 1,2,3-triazole, 1,2,4-triazole, 1-methyl-1,2,4-triazole, methyl-1H-1,2,4-triazole-3-carboxylate,
1,2,4-triazole-3-carboxylic acid, 1,2,4-triazole-3-methyl carboxylate, 1H-1,2,4-triazole-3-thiol, 3,5-diamino-1H-1,2,4-triazole,
3-amino-1,2,4-triazole-5-thiol, 3-amino-1H-1,2,4-triazole, 3-amino-5-benzyl-4H-1,2,4-triazole,
3-amino-5-methyl-4H-1,2,4-triazole,
3-nitro-1,2,4-triazole, 3-bromo-5-nitro-1,2,4-triazole, 4-(1,2,4-triazol-1-yl)phenol, 4-amino-1,2,4-triazole, 4-amino-3,5-dipropyl-4H-1,2,4-triazole,
4-amino-3,5-dimethyl-4H-1,2,4-triazole, 4-amino-3,5 dipeptyl -4H-1,2,4-triazole, 5-methyl-1,2,4-triazole-3,4-diamine, 1H-benzotriazole, 1-hydroxybenzotriazole, 1-aminobenzotriazole, 1-carboxybenzotriazole, 5-chloro-1H-benzotriazole, 5-nitro-1H-benzotriazole, 5-carboxy-1H-benzotriazole, 5-methyl-1H-benzotriazole, 5,6-dimethyl-1H-benzotriazole, 1-(1',2'-di-carboxyethyl)benzotriazole,
1-[N,N-bis(hydroxyethyl)aminomethyl]benzotriazole, 1-[N,N-bis(hydroxyethyl)aminomethyl]-5-methylbenzotriazo le,
1-[N,N-bis(hydroxyethyl)aminomethyl]-4-methylbenzotriazo le, and the like.

Examples of the tetrazole compound include 1H-tetrazole, 5-methyltetrazole, 5-aminotetrazole, 5-phenyltetrazole, and the like.

Examples of the indazole compound include 1H-indazole, 5-amino-1H-indazole, 5-nitro-1H-indazole, 5-hydroxy-1H-indazole, 6-amino-1H-indazole, 5-nitro-1H-indazole, 6-hydroxy-1H-indazole, 3-carboxy-5-methyl-1H-indazole, and the like.

Examples of the indole compound include 1H-indole, 1-methyl-1H-indole, 2-methyl-1H-indole, 3-methyl-1H-indole, 4-methyl-1H-indole, 5-methyl-1H-indole, 6-methyl-1H-indole, 7-methyl-1H-indole, 4-amino-1H-indole, 5-amino-1H-indole, 6-amino-1H-indole, 7-amino-1H-indole, 4-hydroxy-1H-indole, 5-hydroxy-1H-indole, 6-hydroxy-1H-indole, 7-hydroxy-1H-indole, 4-methoxy-1H-indole, 5-methoxy-1H-indole, 6-methoxy-1H-indole, 7-methoxy-1H-indole, 4-chloro-1H-indole, 5-chloro-1H-indole, 6-chloro-1H-indole, 7-chloro-1H-indole, 4-carboxy-1H-indole, 5-carboxy-1H-indole, 6-carboxy-1H-indole, 7-carboxy-1H-indole, 4-nitro-1H-indole, 5-nitro-1H-indole, 6-nitro-1H-indole, 7-nitro-1H-indole, 4-nitrile-1H-indole, 5-nitrile-1H-indole, 6-nitrile-1H-indole, 7-nitrile-1H-indole, 2,5-dimethyl-1H-indole, 1,2-dimethyl-1H-indole, 1,3-dimethyl-1H-indole, 2,3-dimethyl-1H-indole, 5-amino-2,3-dimethyl-1H-indole, 7-ethyl-1H-indole, 5-(aminomethyl)indole, 2-methyl-5-amino-1H-indole, 3-hydroxymethyl-1H-indole, 6-isopropyl-1H-indole, 5-chloro-2-methyl-1H-indole, and the like.

Among these heterocyclic compounds, the triazole compound is preferable. Particularly, 1H-benzotriazole, 5-methyl-1H-benzotriazole, 5,6-dimethyl-1H-benzotriazole, 1-[N,N-bis(hydroxyethyl)aminomethyl]-5-methylbenzotriazo le,
1-[N,N-bis(hydroxyethyl)aminomethyl]-4-methylbenzotriazo le, 1,2,3-triazole, and 1,2,4-triazole are preferable. These heterocyclic compounds have a high chemical or physical adsorption force on the surface of the polishing object, and therefore can form a stronger protective film on the surface of the polishing object. This is advantageous in improving the flatness of the surface of the polishing object after the polishing object is polished using the polishing composition of the present invention.

The surfactant used as the metal corrosion inhibitor may be any of an anionic surfactant, a cationic surfactant, an amphoteric surfactant, and a nonionic surfactant.

Examples of the anionic surfactant include polyoxyethylene alkyl ether acetate, polyoxyethylene alkyl sulfate ester, alkyl sulfate ester, polyoxyethylene alkyl ether sulfate, alkyl ether sulfate, alkyl benzene sulfonate, alkyl phosphate ester, polyoxyethylene alkyl phosphate ester, polyoxyethylene sulfosuccinate, alkyl sulfosuccinate, alkyl naphthalene sulfonate, alkyl diphenyl ether disulfonic acid, and salts thereof, and the like.
Examples of the cationic surfactant include an alkyl trimethyl ammonium salt, an alkyl dimethyl ammonium salt, an alkyl benzyl dimethyl ammonium salt, and an alkylamine salt, and the like.
Examples of the amphoteric surfactant include alkyl betaine and alkylamine oxide, and the like.
Examples of the nonionic surfactant include polyoxyethylene alkyl ether, polyoxyalkylene alkyl ether, a sorbitan fatty acid ester, a glycerin fatty acid ester, a polyoxyethylene fatty acid ester, polyoxyethylene alkylamine, and alkyl alkanol amide, and the like.
Among these surfactants, polyoxyethylene alkyl ether acetate, polyoxyethylene alkyl ether sulfate, alkyl ether sulfate, alkyl benzene sulfonate, and polyoxyethylene alkyl ether are preferable. These surfactants have a high chemical or physical adsorption force on the surface of the polishing object, and therefore can form a stronger protective film on the surface of the polishing object. This is advantageous in improving the flatness of the surface of the polishing object after the polishing object is polished using the polishing composition of the present invention.

[Preservative and fungicide]

Examples of the preservative and fungicide used in the present invention include an isothiazolin-based preservative such as 2-methyl-4-isothiazolin-3-one or 5-chloro-2-methyl-4-isothiazolin-3-one, paraoxybenzoate ester, and phenoxyethanol, and the like. These preservatives and fungicides may be used singly or in mixture of two or more kinds thereof.

[Method for manufacturing polishing composition]

A method for manufacturing the polishing composition of the present invention is not particularly limited. The polishing composition can be obtained by stirring and mixing abrasive grains, an oxidant containing a halogen atom, and if necessary, another component in water.
The temperature when the components are mixed is not particularly limited, but is preferably from 10 to 40°C. The components may be heated in order to increase a dissolution rate. The mixing time is not particularly limited, either.

[Polishing method and method for manufacturing substrate]

As described above, the polishing composition of the present invention is particularly suitably used for polishing a polishing object having a layer containing a IV group material. Therefore, the present invention provides a method for polishing a polishing object having a layer containing a IV group material using the polishing composition of the present invention. In addition, the present invention provides a method for manufacturing a substrate including a process of polishing a polishing obj ect having a layer containing a IV group material by the above-described polishing method.
As a polishing apparatus, it is possible to use a general polishing apparatus including a holder for holding a substrate or the like having a polishing object, a motor or the like having a changeable rotating speed, and a polishing platen to which a polishing pad (polishing cloth) can be attached.
As the polishing pad, a general nonwoven fabric, polyurethane, a porous fluorocarbon polymer, or the like can be used without any particular limitation. The polishing pad is preferably grooved such that a polishing liquid is stored therein.
Polishing conditions are not particularly limited. For example, the rotational speed of the polishing platen is preferably from 10 to 500 rpm, and the pressure (polishing pressure) applied to a substrate having a polishing object is preferably from 0.5 to 10 psi. A method for supplying a polishing composition to a polishing pad is not particularly limited. For example, a polishing composition is supplied continuously using a pump or the like. This supply amount is not limited, but a surface of the polishing pad is preferably covered with the polishing composition of the present invention all the time.
After polishing is terminated, the substrate is washed with running water, followed by drying the substrate by flicking off water droplets adhering to the surface of the substrate by a spin drier or the like. The substrate having a layer containing a IV group material can be thereby obtained.

Examples

The present invention will be described in more detail with the following Examples and Comparative examples. However, the technical scope of the present invention is not limited only to the following Examples.

(Examples 1 to 48 and Comparative examples 1 to 7)

As shown in Table 2, abrasive grains and a sodium hypochlorite aqueous solution (concentration: 5.9% by mass) were stirred and mixed (mixing temperature: about 25°C, mixing time: about 10 minutes) in water to prepare polishing compositions of Examples 1 to 48 and Comparative examples 1 to 7. The pH of the polishing composition was adjusted by adding potassium hydroxide (KOH), and was confirmed to be 9.5 with a pH meter.

Types of the abrasive grains shown in Table 2 are shown in the following Table 1. All of these abrasive grains were synthesized by a sol-gel method.

[Table 1]

| |
|---|
| colloidal silica having an average primary particle diameter of 150 nm |
| colloidal silica having an average primary particle diameter of 34.5 nm |
| colloidal silica having an average primary particle diameter of 31 nm |
| colloidal silica having an average primary particle diameter of 40 nm |
| colloidal silica having an average primary particle diameter of 56.4 nm |
| colloidal silica having an average primary particle diameter of 90 nm |
| colloidal silica having an average primary particle diameter of 76.7 nm |
| colloidal silica having an average primary particle diameter of 35 nm |
| colloidal silica having an average primary particle diameter of 12 nm |

In Table 2, the column "addition amount of NaClO (5.9% by mass)" indicates an addition amount of the NaClO (5.9% by mass) aqueous solution in manufacturing a polishing composition. The column "concentration of oxidant (B)" indicates an amount of an oxidant (NaClO) contained in a manufactured polishing composition.

In Example 31, 0.13% by mass of 2-pyrrolidone was further added to the total mass of the composition. In Example 32, 0.39% by mass of 2-pyrrolidone was further added to the total mass of the composition. In Example 33, 0.65% by mass of 2-pyrrolidone was further added to the total mass of the composition.

As abrasive grains in Example 16 and Comparative examples 2 and 5, colloidal silica on a surface of which sulfonic acid was immobilized was used.

The total number (A) of silanol groups contained in the abrasive grains in the polishing composition was calculated by the following method after each parameter was measured or calculated by the following measuring method or calculating method.

Primary particle diameter [nm] of abrasive grain (measured value) : A diameter (primary particle diameter) of an abrasive grain is calculated based on a specific surface area (SA) calculated by the BET method using a formula of SA = $4\pi R^2$, assuming that the abrasive grain is spherical.

Volume per abrasive grain (calculated value): calculated by the following formula using the primary particle diameter calculated based on the specific surface area (SA)

$$\text{Volume per abrasive grain} = 4/3\pi \times (\text{primary particle diameter of abrasive grain}/2)^3$$

Weight per abrasive grain (calculated value): calculated by the following formula using the calculated volume per abrasive grain

$$\text{Weight per abrasive grain} = \text{volume per abrasive grain} \times \text{specific gravity of abrasive grain (2.2 in colloidal silica)}$$

Surface area per abrasive grain (calculated value): calculated by the following formula using the primary particle diameter calculated based on the specific surface area (SA)

$$\text{Surface area per abrasive grain} = 4\pi \times (\text{primary particle diameter of abrasive grain}/2)^2$$

The number of abrasive grains in polishing composition (calculated value) : calculated by dividing a concentration of the abrasive grains in the polishing composition by a weight per abrasive grain

Total surface area of abrasive grains in polishing composition [$nm^2$] (calculated value) : calculated by a product of the surface area per abrasive grain and the number of the abrasive grains in the polishing composition

The number of silanol groups (measured value): The number of silanol groups per surface area [Silanol count/$nm^2$] determined by a Sears method was calculated.

The Sears method was performed with reference to G. W. Sears, Jr., "Determination of Specific Surface Area of Colloidal Silica by Titration with Sodium Hydroxide", Analytical Chemistry, 28 (12), 1981 (1956). A silica aqueous solution (1 wt%) was used for the measurement. A dropping amount of NaOH added at one time was 0.01 ml and a dropping interval was 30 seconds.

The total number (number) (A) of silanol groups contained in abrasive grains in polishing composition (calculated value): calculated by a product of the number of silanol groups (measured value)[count/nm] determined by the Sears method and the total surface area of the abrasive grains in the polishing composition [$nm^2$] (calculated value) calculated by using the BET specific surface area and the concentration of the abrasive grains in the polishing composition.

Concentration (B) of oxidant (measured value): calculated from an addition amount of a chemical agent when the chemical agent in which the concentration of the oxidant is known is used. Alternatively, quantitative determination is performed by oxidation-reduction titration. For example, in NaClO, quantitative determination is performed by titration using the method No. 318 notified by the Ministry of Health, Labour and Welfare on September 29, 2003.

The number of silanol groups contained in abrasive grains with respect to 1% by mass of oxidant (calculated value) : calculated by dividing the total number (number) (A) of silanol groups contained in the abrasive grains in the polishing composition (calculated value) by the concentration (B) of the oxidant.

A ratio of the remaining oxidant was calculated by the following formula by measuring a content of an oxidant in each of the polishing composition before storage and the polishing composition after storage at 25°C for seven days, using the method No. 318 notified by the Ministry of Health, Labour and Welfare on September 29, 2003.

$$\text{ratio of remaining oxidant (\%)} = (\text{amount of oxidant in polishing composition after storage})/(\text{amount of oxidant in polishing composition before storage}) \times 100$$

For the polishing compositions obtained in Examples 34 to 43, as immersion conditions, a Ge substrate of 3 cm × 3 cm was immersed at 43°C for five minutes (while a stirrer was rotated at 300 rpm), a dissolution amount was calculated from a weight change between before and after the immersion, and the dissolution amount was divided by immersion time to determine an etching rate of the Ge substrate.

The compositions of the polishing compositions in Examples and Comparative Examples, the storage stability of the polishing compositions, and measurement results of a Ge etching rate are shown in Table 2 below.

[Table 2-1]

| | Abrasive grains | | | | | | | Addition amount of NaClO (5.9 % by mass) | Concentration of oxidant (B) | A/B | Ratio of remaining oxidant |
|---|---|---|---|---|---|---|---|---|---|---|---|
| | Primary particle diameter | Concentration | The number of abrasive grains in composition | Surface area per abrasive grain | Total surface area of abrasive grains in composition | The number of silanol groups per abrasive grain | Total number of silanol groups contained in abrasive grains in composition (number) (A) | | | | |
| Unit | nm | g/L | Number | $nm^2$/number | $nm^2$ | Number of silanol/$nm^2$ | | g/kg | % by mass | | % |
| Example 1 | 150 | 35.5 | $9.1\times10^{15}$ | $7.1\times10^{4}$ | $6.5\times10^{20}$ | 2.0 | $1.3\times10^{21}$ | 3.75 | 0.022 | $5.8\times10^{22}$ | 99 |
| Example 2 | 34.5 | 35.5 | $7.5\times10^{17}$ | $3.7\times10^{3}$ | $2.8\times10^{21}$ | 1.7 | $4.8\times10^{21}$ | 3.75 | 0.022 | $2.2\times10^{23}$ | 94 |
| Example 3 | 31 | 35.5 | $1.0\times10^{18}$ | $3.0\times10^{3}$ | $3.1\times10^{21}$ | 2.0 | $6.3\times10^{21}$ | 3.75 | 0.022 | $2.9\times10^{23}$ | 88 |
| Example 4 | 40 | 35.5 | $4.8\times10^{17}$ | $5.0\times10^{3}$ | $2.4\times10^{21}$ | 4.0 | $9.7\times10^{21}$ | 3.75 | 0.022 | $4.4\times10^{23}$ | 72 |
| Examples 5 | 56.4 | 35.5 | $1.7\times10^{17}$ | $1.0\times10^{4}$ | $1.7\times10^{21}$ | 8.0 | $1.4\times10^{22}$ | 3.75 | 0.022 | $6.2\times10^{23}$ | 69 |
| Example 6 | 90 | 35.5 | $4.2\times101^{16}$ | $2.5\times10^{4}$ | $1.1\times10^{21}$ | 14.0 | $1.5\times10^{22}$ | 3.75 | 0.022 | $6.8\times10^{23}$ | 68 |
| Example 7 | 76.7 | 35.5 | $6.8\times10^{16}$ | $1.8\times10^{4}$ | $1.3\times10^{21}$ | 12.0 | $1.5\times10^{22}$ | 3.75 | 0.022 | $6.8\times10^{23}$ | 63 |
| Comparative Example 1 | 35 | 35.5 | $7.2\times10^{17}$ | $3.8\times10^{3}$ | $2.8\times10^{21}$ | 6.5 | $1.8\times10^{22}$ | 3.75 | 0.022 | $8.13\times10^{23}$ | 49 |
| Comparative Example 2 | 35 | 35.5 | $7.2\times10^{17}$ | $3.8\times10^{3}$ | $2.8\times10^{21}$ | 6.5 | $1.8\times10^{22}$ | 3.75 | 0.022 | $8.1\times10^{23}$ | 48 |
| Comparative Example 3 | 12 | 35.5 | $1.8\times10^{19}$ | $4.5\times10^{2}$ | $8.1\times10^{21}$ | 2.6 | $2.1\times10^{22}$ | 3.75 | 0.022 | $9.3\times10^{23}$ | 25 |
| Example 8 | 150 | 35.5 | $9.1\times10^{15}$ | $7.1\times10^{4}$ | $6.5\times10^{20}$ | 2.0 | $1.3\times10^{21}$ | 15.00 | 0.089 | $1.5\times10^{22}$ | 99 |
| Example 9 | 34.5 | 35.5 | $7.5\times10^{17}$ | $3.7\times10^{3}$ | $2.8\times10^{21}$ | 1.7 | $4.8\times10^{21}$ | 15.00 | 0.089 | $5.4\times10^{22}$ | 98 |
| Example 10 | 31 | 35.5 | $1.0\times10^{18}$ | $3.0\times10^{3}$ | $3.1\times10^{21}$ | 2.0 | $6.3\times10^{21}$ | 15.00 | 0.089 | $7.2\times10^{22}$ | 99 |
| Example 11 | 40 | 35.5 | $4.8\times10^{17}$ | $5.0\times10^{3}$ | $2.4\times10^{21}$ | 4.0 | $9.7\times10^{21}$ | 15.00 | 0.089 | $1.1\times10^{23}$ | 97 |
| Example 12 | 90 | 35.5 | $4.2\times10^{16}$ | $2.5\times10^{4}$ | $1.1\times10^{21}$ | 14.0 | $1.5\times10^{22}$ | 15.00 | 0.089 | $1.7\times10^{23}$ | 90 |
| Example 13 | 76.7 | 35.5 | $6.8\times10^{16}$ | $1.8\times10^{4}$ | $1.3\times10^{21}$ | 12.0 | $1.5\times10^{22}$ | 15.00 | 0.089 | $1.7\times10^{23}$ | 89 |
| Example 14 | 56.4 | 35.5 | $1.7\times10^{17}$ | $1.0\times10^{4}$ | $1.7\times10^{21}$ | 8.9 | $1.5\times10^{22}$ | 15.00 | 0.089 | $1.7\times10^{23}$ | 86 |

(continued)

| | Abrasive grains | | | | | | | | | | |
|---|---|---|---|---|---|---|---|---|---|---|---|
| | Primary particle diameter | Concentration | The number of abrasive grains in composition | Surface area per abrasive grain | Total surface area of abrasive grains in composition | The number of silanol groups per abrasive grain | Total number of silanol groups contained in abrasive grains in composition (number) (A) | Addition amount of NaClO (5.9 % by mass) | Concentration of oxidant (B) | A/B | Ratio of remaining oxidant |
| Unit | nm | g/L | Number | $nm^2$/number | $nm^2$ | Number of silanol/$nm^2$ | | g/kg | % by mass | | % |
| Example 15 | 35 | 35.5 | $7.2\times10^{17}$ | $3.8\times10^{3}$ | $2.8\times10^{21}$ | 6.5 | $1.8\times10^{22}$ | 15.00 | 0.089 | $2.0\times10^{23}$ | 88 |
| Example 16 | 35 | 35.5 | $7.2\times10^{17}$ | $3.8\times10^{3}$ | $2.8\times10^{21}$ | 6.5 | $1.8\times10^{22}$ | 15.00 | 0.089 | $2.0\times10^{23}$ | 88 |
| Example 17 | 12 | 35.5 | $1.8\times10^{19}$ | $4.5\times10^{2}$ | $8.1\times10^{21}$ | 2.6 | $2.1\times10^{22}$ | 15.00 | 0.089 | $2.3\times10^{23}$ | 84 |

[Table 2-2]

| | Abrasive grains | | | | | | | Addition amount of NaClO (5.9 % by mass) | Concentration of oxidant (B) | A/B | Ratio of remaining oxidant |
|---|---|---|---|---|---|---|---|---|---|---|---|
| | Primary particle diameter | Concentration | The number of abrasive grains in composition | Surface area per abrasive grain | Total surface area of abrasive grains in composition | The number of silanol groups per abrasive grain | Total number of silanol groups contained in abrasive grains in composition (number) (A) | | | | |
| Unit | nm | g/L | Number | $nm^2$/number | $nm^2$ | Number of silanol/$nm^2$ | | g/kg | % by mass | | % |
| Example 18 | 35 | 3.5 | $7.2\times10^{16}$ | $3.8\times10^{3}$ | $2.8\times10^{20}$ | 6.5 | $1.8\times10^{21}$ | 15.0 | 0.089 | $2.0\times10^{22}$ | 93 |
| Example 19 | 35 | 3.5 | $7.2\times10^{16}$ | $3.8\times10^{3}$ | $2.8\times10^{20}$ | 6.5 | $1.8\times10^{21}$ | 7.5 | 0.044 | $4.1\times10^{22}$ | 92 |
| Example 20 | 35 | 17.7 | $3.6\times10^{17}$ | $3.8\times10^{3}$ | $1.4\times10^{21}$ | 6.5 | $9.0\times10^{21}$ | 15.0 | 0.089 | $1.0\times10^{23}$ | 91 |
| Example 21 | 35 | 3.5 | $7.2\times10^{16}$ | $3.8\times10^{3}$ | $2.8\times10^{20}$ | 6.5 | $1.8\times10^{21}$ | 1.5 | 0.009 | $2.0\times10^{23}$ | 89 |
| Example 22 | 35 | 35.5 | $7.2\times10^{17}$ | $3.8\times10^{3}$ | $2.8\times10^{21}$ | 6.5 | $1.8\times10^{22}$ | 15.0 | 0.089 | $2.0\times10^{23}$ | 91 |
| Example 23 | 35 | 26.6 | $5.4\times10^{17}$ | $3.8\times10^{3}$ | $2.1\times10^{21}$ | 6.5 | $1.3\times10^{22}$ | 11.3 | 0.066 | $2.0\times10^{23}$ | 84 |
| Example 24 | 35 | 17.7 | $3.6\times10^{17}$ | $3.8\times10^{3}$ | $1.4\times10^{21}$ | 6.5 | $9.0\times10^{21}$ | 7.5 | 0.044 | $2.0\times10^{23}$ | 94 |
| Example 25 | 35 | 8.9 | $1.8\times10^{17}$ | $3.8\times10^{3}$ | $6.9\times10^{20}$ | 6.5 | $4.5\times10^{21}$ | 3.75 | 0.022 | $2.0\times10^{23}$ | 84 |
| Example 26 | 35 | 35.5 | $7.2\times10^{17}$ | $3.8\times10^{3}$ | $2.8\times10^{21}$ | 6.5 | $1.8\times10^{22}$ | 7.5 | 0.044 | $4.1\times10^{23}$ | 78 |
| Example 27 | 35 | 17.7 | $3.6\times10^{17}$ | $3.8\times10^{3}$ | $1.4\times10^{21}$ | 6.5 | $9.0\times10^{21}$ | 3.75 | 0.022 | $4.1\times10^{23}$ | 76 |
| Example 28 | 35 | 8.9 | $1.8\times10^{17}$ | $3.8\times10^{3}$ | $6.9\times10^{20}$ | 6.5 | $4.5\times10^{21}$ | 1.5 | 0.009 | $5.1\times10^{23}$ | 73 |
| Example 29 | 35 | 26.6 | $5.4\times10^{17}$ | $3.8\times10^{3}$ | $2.1\times10^{21}$ | 6.5 | $1.3\times10^{22}$ | 3.75 | 0.022 | $6.1\times10^{23}$ | 66 |
| Comparative Example 4 | 35 | 35.5 | $7.2\times10^{17}$ | $3.8\times10^{3}$ | $2.8\times10^{1}$ | 6.5 | $1.8\times10^{22}$ | 3.75 | 0.022 | $8.1\times10^{23}$ | 45 |
| Comparative Example 5 | 35 | 35.5 | $7.2\times10^{17}$ | $3.8\times10^{3}$ | $2.8\times10^{21}$ | 6.5 | $1.6\times10^{22}$ | 3.75 | 0.022 | $8.1\times10^{23}$ | 48 |
| Comparative Example 6 | 35 | 17.7 | $3.6\times10^{17}$ | $3.8\times10^{3}$ | $1.4\times10^{21}$ | 6.5 | $9.0\times10^{21}$ | 1.5 | 0.009 | $1.0\times10^{24}$ | 35 |
| Comparative Example 7 | 35 | 35.5 | $7.2\times10^{17}$ | $3.8\times10^{3}$ | $2.8\times10^{21}$ | 6.5 | $1.8\times10^{22}$ | 1.5 | 0.009 | $2.0\times10^{24}$ | 25 |

[Table 2-3]

| | Abrasive grains | | | | | | | Addition amount of NaClO (5.9 % by mass) | Concentration of oxidant (B) | A/B | Ratio of remaining oxidant |
|---|---|---|---|---|---|---|---|---|---|---|---|
| | Primary particle diameter | Concentration | The number of abrasive grains in composition | Surface area per abrasive grain | Total surface area of abrasive grains in composition | The number of silanol groups per abrasive grain | Total number of silanol groups contained in abrasive grains in composition | | | | |
| Unit | nm | g/L | Number | $nm^2$/number | $nm^2$ | Number of silanol/$nm^2$ | (number) (A) | g/kg | % by mass | | % |
| Example 30 | 35 | 17.7 | $3.6\times10^{17}$ | $3.8\times10^{3}$ | $1.4\times10^{21}$ | 6.5 | $9.0\times10^{21}$ $9.0\times10^{21}$ | 3.75 | 0.022 | $4.1\times10^{23}$ | 76 |
| Example 31 | 35 | 17.7 | $3.6\times10^{17}$ | $3.8\times10^{3}$ | $1.4\times10^{21}$ | 6.5 | $9.0\times10^{21}$ | 3.75 | 0.022 | $4.1x10^{23}$ | 90 |
| Example 32 | 35 | 17.7 | $3.6\times10^{17}$ | $3.8\times10^{3}$ | $1.4\times10^{21}$ | 6.5 | $9.0\times10^{21}$ | 3.75 | 0.022 | $4.1\times10^{23}$ | 92 |
| Example 33 | 35 | 17.7 | $3.6\times10^{17}$ | $3.8\times10^{3}$ | $1.4\times10^{21}$ | 6.5 | $9.0\times10^{21}$ | 3.75 | 0.022 | $4.1\times10^{23}$ | 95 |
| Example 34 | 35 | 0.0001 | $2.0\times10^{12}$ | $3.8\times10^{3}$ | $7.8\times10^{15}$ | 6.5 | $5.1\times10^{16}$ | 50.0 | 0.295 | $1.7\times10^{17}$ | 99 |
| Example 35 | 35 | 0.001 | $2.0\times10^{13}$ | $3.8\times10^{3}$ | $7.8\times10^{16}$ | 6.5 | $5.1\times10^{17}$ | 50.0 | 0.295 | $1.7\times10^{18}$ | 96 |
| Example 36 | 35 | 0.01 | $2.0\times10^{14}$ | $3.8\times10^{3}$ | $7.8\times10^{17}$ | 6.5 | $5.1\times10^{18}$ | 50.0 | 0.295 | $1.7\times10^{19}$ | 99 |
| Example 37 | 35 | 0.1 | $2.0\times10^{15}$ | $3.8\times10^{3}$ | $7.8\times10^{18}$ | 6.5 | $5.1\times10^{19}$ | 50.0 | 0.295 | $1.7\times10^{20}$ | 99 |
| Example 38 | 35 | 1.0 | $2.0\times10^{16}$ | $3.8\times10^{3}$ | $7.8\times10^{19}$ | 6.5 | $5.1\times10^{20}$ | 50.0 | 0.295 | $1.7\times10^{21}$ | 98 |

[Table 2-4]

| | Abrasive grains | | | | | | | Addition amount of NaClO (5.9 % by mass) | Concentration of oxidant (B) | A/B | Ratio of remaining oxidant | Ge etching rate |
|---|---|---|---|---|---|---|---|---|---|---|---|---|
| | Primary particle diameter | Concentration | The number of abrasive grains in composition | Surface area per abrasive grain | Total surface area of abrasive grains in composition | The number of silanol groups per abrasive grain | Total number of silanol groups contained in abrasive grains in composition (number) (A) | | | | | |
| Unit | nm | g/L | Number | $nm^2$/number | $nm^2$ | Number of silanol/$nm^2$ | | g/kg | % by mass | | % | A/min |
| Example 39 | 35 | 10 | $2.0\times10^{17}$ | $3.8\times10^{3}$ | $7.8\times10^{20}$ | 6.5 | $5.1\times10^{21}$ | 7.5 | 0.04 | $1.1\times10^{23}$ | 97 | 6 |
| Example 40 | 35 | 10 | $2.0\times10^{17}$ | $3.8\times10^{3}$ | $7.8\times10^{20}$ | 6.5 | $5.1\times10^{21}$ | 15.0 | 0.09 | $5.7\times10^{22}$ | 90 | 10 |
| Example 41 | 35 | 10 | $2.0\times10^{17}$ | $3.8\times10^{3}$ | $7.8\times10^{20}$ | 6.5 | $5.1\times10^{21}$ | 22.5 | 0.13 | $3.8\times10^{22}$ | 92 | 36 |
| Example 42 | 35 | 10 | $2.0\times10^{17}$ | $3.8\times10^{3}$ | $7.8\times10^{20}$ | 6.5 | $5.1\times10^{21}$ | 37.5 | 0.22 | $2.3\times10^{22}$ | 95 | 267 |
| Example 43 | 35 | 10 | $2.0\times10^{17}$ | $3.8\times10^{3}$ | $7.8\times10^{20}$ | 6.5 | $5.1\times10^{21}$ | 75 | 0.44 | $1.1\times10^{22}$ | 98 | 460 |
| Example 44 | 35 | 10 | $2.0\times10^{17}$ | $3.8\times10^{3}$ | $7.8\times10^{20}$ | 6.5 | $5.1\times10^{21}$ | 86 | 0.50 | $1.0\times10^{22}$ | 90 | 1000 or more |
| Example 45 | 35 | 10 | $2.0\times10^{17}$ | $3.8\times10^{3}$ | $7.8\times10^{20}$ | 6.5 | $5.1\times10^{21}$ | 98 | 0.58 | $8.7\times10^{21}$ | 92 | 1000 or more |
| Example 46 | 35 | 10 | $2.0\times10^{17}$ | $3.8\times10^{3}$ | $7.8\times10^{20}$ | 6.5 | $5.1\times10^{21}$ | 197 | 1.16 | $4.4\times10^{21}$ | 95 | 1000 or more |
| Example 47 | 35 | 10 | $2.0\times10^{17}$ | $3.8\times10^{3}$ | $7.8\times10^{20}$ | 6.5 | $5.1\times10^{21}$ | 295 | 1.74 | $2.9\times10^{21}$ | 92 | 1000 or more |
| Example 48 | 35 | 10 | $2.0\times10^{17}$ | $3.8\times10^{3}$ | $7.8\times10^{20}$ | 6.5 | $5.1\times10^{21}$ | 424 | 2.50 | $2.0\times10^{21}$ | 95 | 1000 or more |

As shown in Table 2 above, it has been found that the polishing composition of the present invention in Examples 1 to 48 having a value (A/B) within a specific range has better storage stability than the polishing compositions in Comparative Examples. In addition, it has been found that addition of the stability improver further improves the storage stability.

The present application is based on the Japanese patent application No. 2013-204170 filed on September 30, 2013, and a disclosed content thereof is incorporated herein as a whole by reference.

## Claims

1. A polishing composition comprising abrasive grains and an oxidant containing a halogen atom, wherein a value (A/B) obtained by dividing the total number (A) (unit: number) of silanol groups contained in the abrasive grains in the polishing composition by a concentration (B) (unit: % by mass) of the oxidant in the polishing composition is $8 \times 10^{23}$ or less.

2. The polishing composition according to claim 1, used for polishing a polishing object having a layer containing a IV group material.

3. The polishing composition according to claim 1 or 2, wherein the concentration of the oxidant is 0.0001% by mass or more and less than 0.5% by mass.

4. A method for polishing a polishing object having a layer containing a IV group material using the polishing composition according to any one of claims 1 to 3.

5. A method for manufacturing a substrate comprising polishing a polishing object having a layer containing a IV group material by the polishing method according to claim 4.

## INTERNATIONAL SEARCH REPORT

International application No.
PCT/JP2014/073076

A. CLASSIFICATION OF SUBJECT MATTER
*C09K3/14*(2006.01)i, *B24B37/00*(2012.01)i, *C09G1/02*(2006.01)i, *H01L21/304*(2006.01)i

According to International Patent Classification (IPC) or to both national classification and IPC

B. FIELDS SEARCHED

Minimum documentation searched (classification system followed by classification symbols)
C09K3/14, B24B37/00, C09G1/02, H01L21/304-201/306

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2011-513991 A (Cabot Microelectronics Corp.), 28 April 2011 (28.04.2011), claims; paragraph [0021]; example 4, polishing composition 4O (paragraphs [0051] to [0054]); example 10, polishing compositions 10C, 10F, 10G, 10H (paragraphs [0080] to [0084]) & JP 2010-503232 A & JP 5385141 B & US 2008/0153292 A1 & US 2008/0057713 A1 & US 2008/0153293 A1 & EP 2255379 A2 & WO 2009/111001 A2 & WO 2008/030420 A1 & IL 207886 A & KR 10-2011-0007118 A & CN 102017093 A & MY 146015 A & KR 10-2009-0051263 A & CN 101512732 A & MY 145601 A & SG 174764 A & TW 200821375 A | 1-5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 November, 2014 (18.11.14) | 02 December, 2014 (02.12.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/073076

C (Continuation). DOCUMENTS CONSIDERED TO BE RELEVANT

| Category* | Citation of document, with indication, where appropriate, of the relevant passages | Relevant to claim No. |
|---|---|---|
| X | JP 2008-264952 A (Shin-Etsu Chemical Co., Ltd.), 06 November 2008 (06.11.2008), claims; example 16 (paragraphs [0025] to [0027]) (Family: none) | 1-5 |
| X | JP 2010-041029 A (JSR Corp.), 18 February 2010 (18.02.2010), claims; paragraphs [0037] to [0039], [0061], [0079]<br>& US 2011/0081780 A1 & WO 2009/104517 A1<br>& KR 10-2010-0111277 A & TW 200944583 A<br>& JP 2009-224771 A & JP 2010-16346 A<br>& JP 2010-28080 A & JP 2010-28081 A<br>& JP 2010-28082 A & JP 2010-34498 A | 1-5 |
| A | JP 2000-230170 A (Sharp Corp.), 22 August 2000 (22.08.2000), claims<br>& US 6290736 B1 & TW 522167 B<br>& KR 10-2000-0057939 A | 1-5 |
| A | JP 2001-342456 A (Praxair S.T. Technology, Inc.), 14 December 2001 (14.12.2001), claims<br>& US 6299795 B1 & US 6491837 B1<br>& EP 1118647 A1 & CN 1333317 A<br>& TW 290574 B & SG 90227 A | 1-5 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4944836 A
- JP 2004172326 A
- JP 2010130009 A
- US 8338302 B
- JP 2010519740 W
- US 2011117740 A
- JP 2013204170 A


### Non-patent literature cited in the description


- Sulfonic acid-functionalized silica through quantitative oxidation of thiol groups. *Chem. Commun.,* 2003, 246-247
- Novel Silane Coupling Agents Containing a Photolabile 2-Nitrobenzyl Ester for Introduction of a Carboxy Group on the Surface of Silica Gel. *Chemistry Letters,* 2000, vol. 3, 228-229
- **G.W. SEARS, JR.** Determination of Specific Surface Area of Colloidal Silica by Titration with Sodium Hydroxide. *Analytical Chemistry,* 1956, vol. 28 (12), 1981
- **G. W. SEARS, JR.** Determination of Specific Surface Area of Colloidal Silica by Titration with Sodium Hydroxide. *Analytical Chemistry,* 1956, vol. 28 (12), 1981